Europäisches Patentamt

European Patent Office

Office européen des brevets

(19)

(11) Publication number: **0 266 214**
**A2**

(12) # EUROPEAN PATENT APPLICATION

(21) Application number: 87309609.3

(22) Date of filing: 30.10.87

(51) Int. Cl.⁴: **G 02 B 1/10**
**G 02 B 6/12**

(30) Priority: 31.10.86 JP 258284/86

(43) Date of publication of application:
04.05.88 Bulletin 88/18

(84) Designated Contracting States: **DE FR GB IT NL**

(71) Applicant: **HITACHI, LTD.**
**6, Kanda Surugadai 4-chome**
**Chiyoda-ku Tokyo 101 (JP)**

(72) Inventor: **Miura, Yuuji**
**10-35, Ayukawa-cho 1-chome**
**Hitachi-shi Ibaraki 316 (JP)**

**Baba, Noboru**
**3161-8, Mayumi-cho**
**Hitachioota-shi Ibaraki 313 (JP)**

(74) Representative: **Ellis, Edward Lovell et al**
**MEWBURN ELLIS & CO. 2/3 Cursitor Street**
**London EC4A 1BQ (GB)**

(54) Interference film filters, optical waveguides and methods for producing them.

(57) Interference film filters and optical waveguides with low loss of light, including a laminate deposition-formed on a substrate (1,30) by alternate sputtered lamination of a first film (2,4,10) of amorphous $Si_xC_yO_z$ (x:y:z = 1:0.6-1:0-0.5) having refractive index up to 3.4 and an extinction coefficient below 0.1 and a second thin film (3,5,20) of amorphous $Si_xO_yC_z$ (x:y:z = 1:1.8-2:0-0.5) having a low refractive index in comparison with that of the first thin film. The two film types may be sputtered from a single sintered SiC target by varying oxygen content of a sputter gas mixture.

*FIG. 1*

EP 0 266 214 A2

## Description

"INTERFERENCE FILM FILTERS, OPTICAL WAVEGUIDES AND METHODS FOR PRODUCING THEM".

The present invention relates to interference film filters such as are used in optical multiplexers and demultiplexers in optical communication systems and optical microscopes, and to optical waveguides such as are used for optical measurement systems and optical integrated circuits. It also relates to methods for producing interference film filters and optical waveguides.

JP-A-60-87302 (1985) discloses an interference film filter including alternating lamination of a thin $TiO_2$ film having a high refractive index of 2.2 with a thin $SiO_2$ film having a low refractive index of 1.46.

JP-A-60-114811 (1985) (corresponding to U.S. Serial No. 06/674,770, filed on November 26, 1984 and assigned to the present applicant) discloses stepped and graded optical waveguides including as a core portion an oxynitride film composed of silicon oxide and silicon nitride and having a high refractive index of 1.72 at a wavelength of $0.633\mu m$ (the wavelength generated by He-Ne gas lasers) and as a clad portion an oxynitride film composed of silicon oxide and silicon nitride and having a low refractive index of 1.65-1.69 at a wavelength of $0.633\mu m$. The oxynitride films are deposition-formed by sputtering a polycrystalline silicon in a sputter gas containig $O_2$ and $N_2$ gases, and their refractive indexes are controlled by adjusting the $O_2$ gas content in the sputter gas.

JP-A-60-37504 (1985) discloses stepped and graded optical waveguides comprising a core portion formed of an alternating lamination of a thin $TiO_2$ film having a high refractive index of 2.3 with a thin $SiO_2$ film having a low refractive index of 1.477 at a wavelength of $0.633\mu m$. The laminate is then heat-treated to form a core portion having a uniform composition and a refractive index between 1.477 and 2.3.

In interference film and optical waveguides, when a thin film having a high refractive index n with thickness d exhibits a local maximum transmittance at a wavelength , the following equation generally holds:

$$d = \frac{\lambda}{4n}(2m+1) \quad (m=0,1,2,3,...)$$

The above equation indicates that the film thickness decreases with increasing refractive index of the film. So on one hand, loss of light generally decreases with a decrease in thickness of the film.

Loss of light in inteference film filters and optical waveguides is further reduced in dependence upon the extinction coefficient specific to the material of the thin film. The extinction coefficient represents a degree of light absorption in the thin film material, whereby the smaller the extinction coefficient, the smaller the loss of the light in the film. Until now, it was considered that the extinction coefficient of an optical material in general increases with increase of the refractive index thereof.

The refractive index and extinction coefficient of the $TiO_2$ thin film conventionally used for interference film filters and optical waveguides are respectively 2.3 and 0.5-1.0, which are not necessarily satisfactory to keep down loss of light in these filters and waveguides.

The present invention addresses the problem of providing an interference film filter or optical waveguide with a small loss of light, preferably to provide a filter or waveguide with a high refractive index thin film or core having a higher refractive index and smaller extinction coefficient than those of the conventional $TiO_2$ thin film.

It is also sought to provide a method for producing an interference film filter or an optical waveguide with low production time and production cost, preferably less than in conventional procedures.

Accordingly, the invention provides an interference film filter or optical waveguide that includes a substrate such as glass, plastic or silicon wafer and a laminate supported on the substrate, the laminate being formed of at least one alternating lamination of the first thin film of amorphous $Si_xC_yO_z$ having a high refractive index of up to 3.4, wherein $x > 0$, $y > z$ and $z \geqq 0$, and a second thin film having a low refractive index in comparison with that of the first thin film. The values of y and z in the amorphous $Si_xC_yO_z$ are preferably in respective ranges of 0.6-1 and 0-0.5 with a relative z value of 1. The second thin film is preferably amorphous $Si_xO_yC_z$, wherein $x > 0$, $y > z$, and $z \geqq 0$, with values of y and z relative to an assumed x value of 1 in respective ranges of 1.8-2 and 0-0.5.

There is also provided a method for producing an interference film filter or optical waveguide including a substrate and a laminate supported on the substrate, wherein the laminate is formed by sputtering deposition of at least one alternating lamination of a first thin film, having a high refractive index and a second thin film having a low refractive index in comparison with that of the first thin film, the method comprising a step of depositing an amorphous $Si_xC_yO_z$ film, wherein y is 0.6-1 and z is 0-0.5 relative to an x value of 1, by sputtering an SiC sinter target and controlling the $O_2$ gas content in a mixture sputter gas of an inert gas e.g. argon (Ar), helium (He), neon (Ne), Krypton (Kr) or xenon (Xe), and oxygen gas in a range of 0-5wt% so as to form the first thin film, and a step of depositing an amorphous $Si_xO_yC_z$ film, wherein y is 1.8-2 and z is 0.05 relative to an x value of 1, by sputtering the same common SiC sinter target and controlling the $O_2$ gas content in the mixture sputter gas to fall in a range of 10-20wt%, thereby forming the second thin film.

The resultant first thin film of amorphous $Si_xC_yO_z$ may exhibit a refractive index of up to 3.4 at a wavelength of 0.633 $\mu m$, which is much higher than the refractive index 2.3 of a $TiO_2$ thin film, and an extinction coefficient below 0.1, which is much smaller than the extinction coefficient 0.5 to 1.0 of a conventional $TiO_2$ thin film.

The resultant second thin film of amorphous $Si_xO_yC_z$ may exhibit properties substantially equivalent to those of a SiO₂ thin film, i.e. a refractive index of 1.4 to 1.5 at a wavelength of 0.633μm and an extinction coefficient of substantially zero.

The low refractive index thin film or clad portion of the present invention may instead of a thin film of amorphous $Si_xO_yC_z$ comprise a conventional sputtered thin film of some other material having alow refractive index, e.g. SiO₂ and oxynitride composed of silicon oxide and silicon nitride. In this case however the sputtering target and the sputter gas have to be changed for the second film formation, which prolongs the production time and increases the production cost, as well as interrupting continuous operation. Moreover, during exchange of the sputter target dust is likely to deposit on the surface of the previously formed film so as to reduce the quality of the resulting product.

Embodiments of the invention will now be described by way of example with reference to the accompanying drawings, in which:

Fig. 1 is a sectional view of an interference film filter;

Fig. 2 is a sectional view of a different interference film filter; and

Fig. 3 is a sectional view of an optical waveguide.

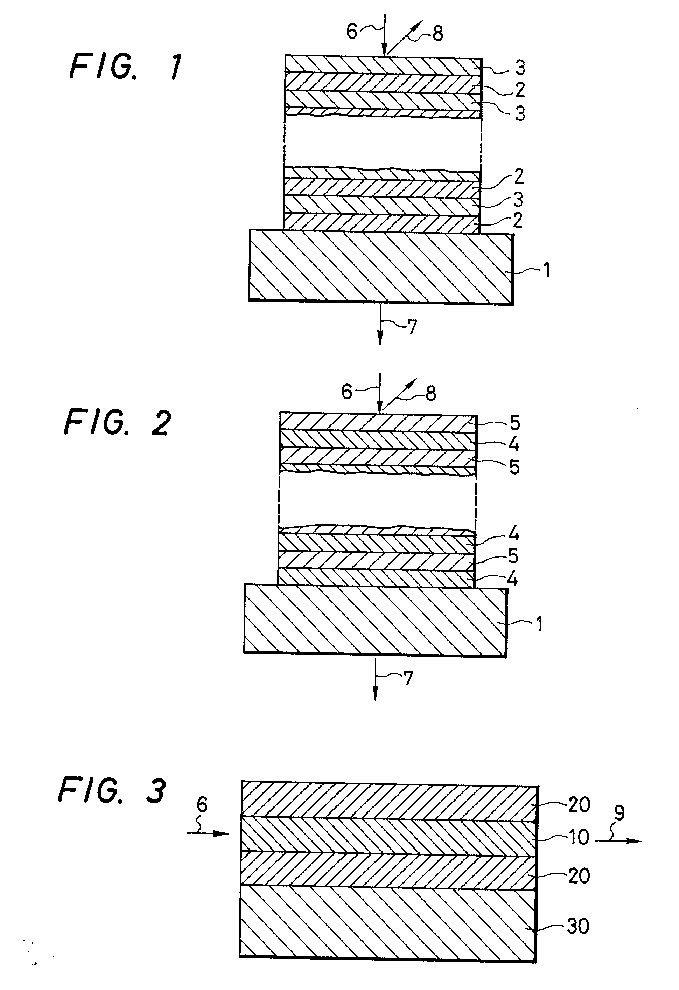

The interference film filter shown in Fig. 1 was produced as follows:

An amorphous $Si_xC_y$ film 2 (x = 0.6, y = 0.4) having thickness of 490Å was deposited on a glass substrate 1 by sputtering in an argon gas with a SiC sinter target for 2.5 minutes. Sputter power was 200W and sputter gas pressure $1×10^{-2}$ Torr. The same SiC sinter target was then sputtered in a sputter gas mixture consisting of argon with 15wt% of oxygen for 5 minutes so as to deposit an amorphous $Si_xO_y$ film 3 (x = 0.4, y = 0.8) having a thickness of 1000Å on top of the first film 2. By repeating the above operation a laminate having several tens of films supported on the glass substrate 1 was produced, with films of the two types above 2,3 alternating.

The amorphous $Si_xC_y$ film 2 (x = 0.6, y = 0.4) and the amorphous $Si_xO_y$ film 3 (x = 0.4, y = 0.8) had refractive indexes of 3.2 and 1.4 respectively.

Arrows indicated by numerals 6,7 and 8 show the respective directions of incident light, transmitted light and reflected light in relation to the resulting interference film filter.

The interference film filter shown in Fig. 2 was produced in substantially the same way as that of Fig. 1. An amorphous $Si_xC_yO_z$ film 4 (x = 0.5, y = 0.4, z = 0.5) having a thickness of 630Å was deposited on the glass substrate 1 by sputtering in a sputter gas mixture consisting of argon with 5wt% of oxygen, using the same SiC sinter target, for 3 minutes. Sputter power was 200W and sputter gas pressure $1×10^{-2}$ Torr. Then an amorphous $Si_xO_yC_z$ film 5 (x = 0.4, y = 0.8, z = 0.1) having a thickness of 980Å was deposited on the first $Si_xC_yO_z$ film 4 using the same SiC sinter target and a sputter gas mixture consisting of argon gas with 10wt% of oxygen for 5 minutes. The above operations were repeated so that amorphous $Si_xC_yO_z$ films 4 and amorphous $Si_xO_yC_z$ films 5 were laminated upon one another alternately in a number of several tens of films.

The amorphous $Si_xC_yO_z$ films 4 (x = 0.5, y = 0.4, z = 0.5) and the amorphous $Si_xO_yC_z$ films (x = 0.4, y = 0.8, z = 0.1) had refractive indexes of 2.5 and 1.6 respectively.

Arrows indicated by numerals 6,7 and 8 show the respective directions of incident light, transmitted light and reflected light in relation to the resulting interference film filter.

Fig. 3 shows an optical waveguide produced in a manner somewhat similar to that used to produce the interference film filters of Figs. 1 and 2. Specifically, an amorphous $Si_xO_yC_z$ film 20 (x:y:z = 1:1.8-2:0-0.5) having a thickness of 5-30μm, which constitutes a clad portions, was deposited on a glass substrate 30, by sputtering in a sputter gas mixture consisting of argon with 10-20wt% of oxygen for 250-1500 minutes; sputter power was 200W and sputter gas pressure was $1×10^{-2}$ Torr. The same common SiC sinter target was then sputtered in a sputter gas mixture consisting of argon gas and 0-5wt% of oxygen for 50-500 minutes so as to deposit an amorphous $Si_xC_yO_z$ film 10 (x:y:z = 1:0.6-1:0-0.5) having a thickness of 1-10μm, and consituting a core portion, on the amorphous $Si_xO_yC_z$ film 20 formed previously. Finally the same common SiC sinter target was again sputtered, under the same conditions as for the first film 20, to deposit another amorphous $Si_xO_yC_z$film 20 (x:y:z = 1:1.8-2:0-05) on the amorphous $Si_xC_yO_z$ film 10.

The respective refractive indexes of the amorphous $Si_xC_yO_z$film 10 and the amorphous $Si_xO_yC_z$ films 20 were 1.8-3.2 and 1.4-1.8.

Arrows indicated by numerals 6 adn 9 show the respective directions of incident light and guided light in relation to the resulting optical waveguide.

The embodiment of Fig. 3 shows a stepped type optical waveguide. However a core portion having a predetermined refractive index distribution is easily formed to constitute a graded type optical waveguide, by using a common SiC sinter target throughout and adjusting the oxygen concentration in the sputter gas mixture gradually. Amorphous $Si_xC_yO_z$ film or amorphous $Si_xO_yC_z$ film with refractive index that may range from 1.4 to 3.4 is thereby freely depositin-formed by a method embodying the present invention.

The deposition films produced by the processes described above were confirmed as being in the forms of amorphous $Si_xC_yO_z$ and amorphous $Si_xO_yC_z$, by analysis and examination using an ion microanalyzer, an electron microscope and an infrared absorption spectrum.

## Claims

1. An interference film filter or optical waveguide including a substrate (1,30) and a laminate supported on said substrate (1,30), characterized in that said laminate is formed of at least one lamination of a first thin film (2,4,10) of amorphous $Si_xC_yO_z$, wherein x > 0, y > z and

$z \geqq 0$, alternating with a second thin film (3,5,20) having a low refractive index in comparison with that of said first thin film (2,4,10).

2. An interference film filter or optical waveguide according to claim 1, wherein said second thin film (3,5,20) is amorphous $Si_xO_yC_z$ with $x > 0, y > z$ and $z \geqq 0$.

3. An interference film filter or optical waveguide according to claim 1 or claim 2, wherein y and z of said amorphous $Si_xC_yO_z$ are respectively in the ranges 0.6-1 and 0-0.5 relative to an assumed x of 1.

4. An interference film filter or optical waveguide according to claim 2 or claim 3 wherein y and z of said amorphous $Si_xO_yC_z$ are respectively in the ranges 1.8-2 and 0-0.5 relative to an assumed x of 1.

5. An interference film filter or optical waveguide according to any one of the preceding claims wherein the thickness of respective plural first thin films (2,4,10) are substantially the same and the thicknesses of respective plural second thin films (3,5,20) are substantially the same.

6. An interference film filter or optical waveguide according to any one of the preceding claims wherein said substrate (1,30) is made of transparent material.

7. An optical waveguide according to any one of the preceding claims wherein said substrate comprises a silicon wafer.

8. A method for producing an interference film filter or an optical waveguide by sputter deposition of successive thin films, characterized by:

adjusting the proportion of oxygen in a sputter gas mixture of an inert gas and oxygen to a first predetermined value;

sputtering a sintered SiC target in said sputter gas mixture to deposit a first thin film (2,4,20) on a substrate (1,30);

readjusting the proportion of oxygen in the sputter gas mixture to a second predetermined value, and

sputtering the sintered SiC target in the readjusted sputter gas mixture to deposit a second thin film (3,5,10) on the first thin film (2,4,20).

9. A method according to claim 8 wherein the first and second predetermined values lie in ranges of 0-5wt% and 10-20wt% respectively, whereby the first thin film (2,4) is formed of amorphous $Si_xC_yO_z$ wherein y is 0.6-1 and z is 0-0.5 relative to an assumed x of 1, and the second thin film (3,5) is formed of amorphous $Si_xO_yC_z$ wherein y is 1.8-2 and z is 0-0.5 relative to an assumed x of 1.

10. A method according to claim 8 wherein the first and second predetermined values lie in ranged of 10-20wt% and 0-5wt% respectively, whereby the first thin film (20) is formed of amorphous $Si_xO_yC_z$ wherein y is 1.8-2 and z is 0-0.5 relative to an assumed x of 1, and the second thin film (10) is formed of amorphous $Si_xC_yO_z$ wherein y is 0.6-1 and z is 0-0.5 relative to an assumed x of 1.

*FIG. 1*

6    8
3
2
3

2
3
2

1

7

*FIG. 2*

6    8
5
4
5

4
5
4

1

7

*FIG. 3*

6
20
9
10
20
30